# EUROPÄISCHE PATENTSCHRIFT

(11) **EP 0 627 812 B1**
(45) Veröffentlichungstag und Bekanntmachung des Hinweises auf die Patenterteilung: **03.02.1999**
(21) Anmeldenummer: 94107811.5
(22) Anmeldetag: 20.05.1994
(51) Int. Cl.: H03B 5/18

(54) **Spannungsgesteuerter Mikrowellenoszillator**
Microwave voltage controlled oscillator
Oscillateur micro-onde commandé en tension

(30) Priorität: 26.05.1993 DE 4317425
(43) Veröffentlichungstag der Anmeldung: 07.12.1994
(73) Patentinhaber: Daimler-Benz Aerospace Aktiengesellschaft, 81663 München (DE)
(72) Erfinder: Güttich, Ulrich, Dr. Dipl.-Ing., D-89233 Neu-Ulm/Burlafingen (DE)
(74) Vertreter: Fröhling, Werner Otto, Dr.

(56) Entgegenhaltungen:
- EP-A- 0 510 709
- US-A- 4 463 322
- US-A- 4 630 004
- ALTA FREQUENZA, Bd.LVII, Nr.7, September 1988, MILANO IT Seiten 389 - 398, XP000111825 V. RIZZOLI ET AL. 'Analysis and Optimization of DRO's Using a General-Purpose CAD Program'

## Beschreibung

Die Erfindung bezieht sich auf einen spannungsgesteuerten Mikrowellenoszillator in Planartechnik gemäß dem Oberbegriff des Patentanspruchs 1. Ein solcher Oszillator ist bereits aus dem Artikel von V. Rizzoli, A. Constanzo, A. Neri: "Analysis and Optimization auf DRO's Using a General-Purpose CAD-Program"; in: Alta Frequenza, Vol. LVII-Nr. 7 (September 1988), Seiten 389-398 bekannt.

Oszillatoren dieser Art werden beispielsweise als rauscharme Referenzoszillatoren ("local oscillator") eingesetzt, die über eine Steuerspannung in der Frequenz abstimmbar sind (z.B. zur Frequenzmodulation oder zur Kompensation von alters- bzw. temperaturbedingter Frequenzdrift).

Der eingangs zitierte spannungsgesteuerte Mikrowellenoszillator von Rizolli et. al. weist einen Mikrowellentransistor als aktives Bauelement sowie ein daran angeschlossenes frequenzbestimmendes Schaltungsnetzwerk auf, das eine Varaktordiode und einen dielektrischen Resonator enthält. Bei dieser Lösung ist der dielektrische Resonator über eine erste Streifenleitung an das Schaltungsnetzwerk angekoppelt. Der Mikrowellentransistor ist mit einem seiner drei Tore (dem Gate-Anschluß) über die Varaktordiode an das eine Ende der ersten Streifenleitung angeschlossen.

Aus dem Artikel von A. P. S. Khanna und E. Topacio: "A Highly-Stable 36 GHz GaAs FET DRO with Phase-Lock Capability"; in: Microwave Journal, July 1989, Seiten 117-122 ist ein spannungsgesteuerter Mikrowellenoszillator bekannt, der aus einem mikrowellentauglichen Feldeffekttransistor (FET) als aktivem Bauelement und einem über das Gate (G) an den FET angeschlossenen frequenzbestimmenden Schaltungsnetzwerk besteht, das einen dielektrischen Resonator sowie eine Varaktordiode enthält. Bei diesem Schaltungsnetzwerk ist das Gate des FET über eine erste Streifenleitung und einen Abschlußwiderstand an Masse angeschlossen, während die Varaktordiode mit ihrem einen Anschluß über eine Induktivität an eine Gleichspannungsquelle angeschlossen ist und mit ihrem anderen Anschluß an eine zweite Streifenleitung. Zwischen den beiden Streifenleitungen ist der dielektrische Resonator angeordnet, der über diese beiden Leitungen an das Schaltungsnetzwerk angekoppelt ist.

Diese Art der Ankopplung schränkt in der Praxis die Justiermöglichkeiten für den Resonator erheblich ein und setzt beim monolithischen Aufbau der Schaltung auf einem einzigen Substrat eine sehr große Chipfläche voraus, da der Resonator auch auf diesen Chip Platz finden muß und nicht auf einen benachbarten Trägersubstrat untergebracht werden kann. Aus der EP-A1 0 510 709 ist eine planare Oszillatorschaltung bekannt, die zwei getrennte Substrate aufweist.

Die Aufgabe der Erfindung besteht darin, einen spannungsgesteuerten Mikrowellenoszillator der eingangs genannten Art dahingehend zu verbessern, daß im Hinblick auf eine möglichst wirtschaftliche Herstellung insbesondere bei der monolithischen Integration der Oszillatorschaltung eine möglichst kleine Chipfläche für die Schaltung benötigt wird.

Die erfindungsgemäße Lösung dieser Aufgabe ist durch die kennzeichnenden Merkmale des Patentanspruchs 1 wiedergegeben. Die übrigen Ansprüche enthalten vorteilhafte Aus- und Weiterbildungen der Erfindung.

Der wesentliche Vorteil der Erfindung besteht darin, daß für die Schaltung nur eine sehr kleine Chipfläche benötigt wird, da sich alle wesentlichen Elemente der Schaltung - vom dielektrischen Resonator aus gesehen - auf einer Seite befinden und der dielektrische Resonator als das weitaus größte Einzelelement der Schaltung bei dieser Lösung ohne weiteres auch auf einem separaten (passiven) Stützsubstrat, das neben dem Substrat mit dem übrigen gegebenenfalls monolithisch integrierten Teil der Schaltung angeordnet ist, angebracht werden kann.

Diese Ankopplung des (ggf. auf einem separaten Trägersubstrat angeordneten) Resonators nur an einer Stelle erleichtert die Justierung des Resonators ganz erheblich, da dieser ohne große Schwierigkeiten auf der Substratoberfläche verschoben werden kann. Die Anordnung auf einem separaten Trägersubstrat und der dadurch zwangsläufig entstehende Luftspalt zwischen den beiden Substraten hat sich dabei in der Praxis als unkritisch erwiesen.

Da die Chipgröße bei separatem Trägersubstrat für den Resonator nunmehr nur noch von der Größe der weitaus kleineren übrigen Schaltung abhängt, werden die Dimensionen und damit die Herstellungskosten bei einer monolithischen Integration der Oszillatorschaltung erheblich reduziert.

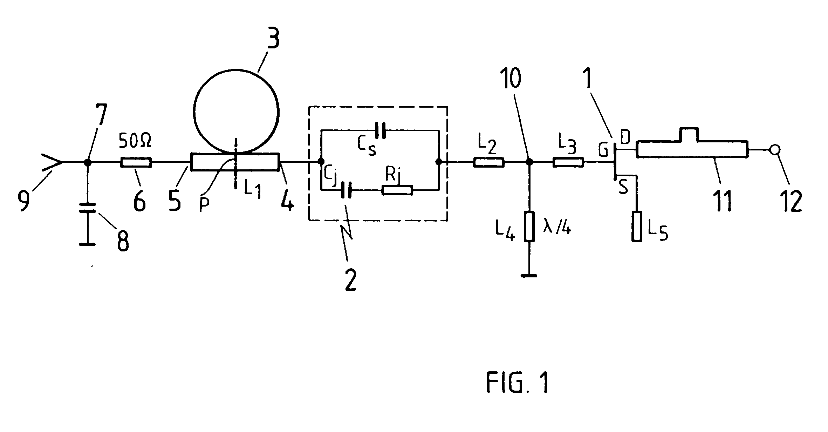

Im folgenden wird die Erfindung an Hand der Figur 1 näher erläutert. Sie zeigt das Blockschaltbild einer bevorzugten Ausführungsform des erfindungsgemäßen Mikrowellenoszillators.

Bei dieser Schaltung kann als aktives Element ein mikrowellentauglicher bipolarer Transistor oder Feldeffekttransistor (FET) verwendet werden. Es sind dabei alle drei Oszillatorgrundschaltungen (Basis-, Kollektor- oder Emitter-Schaltung (Bipolartransistor) bzw. Gate-, Drain- oder Source-Schaltung (FET)) möglich. In der Figur wurde beispielhaft ein FET in der Source-Schaltung gewählt. Im einzelnen ist der FET 1 über sein Gate G an ein sternförmig ausgebildetes Streifenleitungs-Netzwerk L₂, L₃ und L₄ angeschlossen, dessen eine Enden an einen gemeinsamen Verbindungspunkt 10 angeschlossen sind und die mit ihren anderen Enden jeweils an das Gate G des Mikrowellentransistors 1 (dritte Streifenleitung L₃) bzw. an den einen Anschluß einer (als Ersatzschaltbild dargestellten) Varaktordiode 2 (zweite Streifenleitung L₂) bzw. an Masse (vierte Streifenleitung L₄) angeschlossen sind. Die Varaktordiode 2 ihrerseits ist mit ihrem anderen Ende an das eine Ende 4 einer ersten Streifenleitung L₁ angeschlossen, die ihrerseits mit ihrem anderen Ende 5 über einen 50 Ω-Abschlußwiderstand 6 an eine Gleichspannungsquelle 9 angeschlossen ist. Zwischen der Gleichspannungsquelle 9 und dem 50 Ω-Abschlußwiderstand 6 ist ein Anschlußpunkt 7 über einen Kondensator 8 an Masse angeschlossen.

Die erste Streifenleitung L₁ dient als Ankoppelelement für einen dielektrischen Resonator 3 (Ankopplung am Punkt P), der entweder auf dem gleichen Trägersubstrat angeordnet sein kann wie die übrigen Oszillatorschaltung oder - alternativ hierzu - auf einem separaten (passiven) Stützsubstrat, das neben dem eigentlichen Trägersubstrat angeordnet ist (das oder die Substrate sind in der FIG. 1 nicht gezeigt).

Der Source-Anschluß des FET 1 ist an eine fünfte Streifenleitung L₅ angeschlossen zur Erzeugung eines negativen Widerstands am Drain-Anschluß D; der Drain-Anschluß D des FET 1 ist über ein Anpaßnetzwerk 11 an den Oszillatorausgang 12 angeschlossen. Die Länge der vierten Streifenleitung L₄ des Streifenleitungs-Netzwerkes L₂-L₄ ist gleich oder zumindest annähernd gleich einem Viertel der Wellenlänge (λ/4) der Schwingfrequenz des Oszillators.

Über die Streifenleitung L₅ wird eine Serienrückkopplung erreicht. Der dabei erzeugte negative Widerstand am Drain-Anschluß D wird mittels des Ausgangsanpaßnetzwerks 11 an die Umgebungsimpedanz angepaßt. Die Längen der Streifenleitung L₁ bis L₄ werden so optimiert, daß die Ausgangsleistung des Oszillators maximal ist. Die Varaktordiode 2 (hier dargestellt als Ersatzschaltbild bestehend aus der Serienkapazität Cₛ, dem Junction-Widerstand Rⱼ und der Junction-Kapazität Cⱼ) befindet sich zwischen den Streifenleitungen L₁ und L₄. Die Streifenleitung L₁ ist jenseits des dielektrischen Resonators 3 hochfrequenzmäßig mit dem 50 Ω-Widerstand 6 abgeschlossen (Kapazität 8 auf Masse), um unerwünschte Schwingungen zu unterdrücken. Die Varaktordiode 2 wird über diesen Widerstand 6 mit Gleichspannung der Gleichspannungsquelle 9 betrieben. Die λ/4-lange Streifenleitung L₄ ist gleichstrommäßig sowohl für die Varaktordiode 2 als auch für ein Tor des Transistors 1 (in FIG. 1 der Gate-Anschluß G) der Massepunkt. Bei Variation der Spannung an der Varaktordiode 2 ändert sich deren Impedanz und damit die Impedanz des gesamten frequenzbestimmenden Netzwerks, bestehend aus den Leitungen L₁ bis L₅ sowie der Varaktordiode 2 und dem dielektrischen Resonator 3. Es ist somit eine Frequenzverschiebung möglich, solange der Gütebereich des Resonators 3 nicht verlassen wird (typische Werte sind 0.1 bis 0.3 %). Trotzdem behält der Oszillator über den Ziehbereich das rauscharme Spektrum eines dielektrisch stabilisierten Oszillators (DRO = "Dielectric Resonator stabilized Oscillator") und eine praktisch konstante Ausgangsleistung.

Messungen an einem monolithischen Oszillator dieser Art für etwa 30 GHz ergaben eine Ausgangsleistung von typisch +8dBm über einen Ziehbereich von etwa 50 MHz. Das Hochfrequenzspektrum wies bei etwa 100 kHz Ablage ein Phasenrauschen von etwa -100 dBc/Hz auf.

Die Erfindung ist nicht auf das geschilderte Ausführungsbeispiel beschränkt, sondern vielmehr auf weitere übertragbar.

So ist es z.B. möglich, daß der dielektrische Resonator derart auf einem separaten Trägersubstrat aufgebracht wird, das neben dem Substrat mit der aktiven Schaltung angeordnet ist, daß der Resonator über das separate Trägersubstrat und über den Luftspalt zwischen den beiden Substraten hinausragt und mit einem kleinen Teil seiner Auflagefläche auf dem Substrat mit der monolithisch integrierten Schaltung zu liegen kommt.

Während das Substrat für die monolithisch integrierte Schaltung aus einem Halbleitermaterial (GaAs, Si) bestehen muß, kann das separate (passive) Trägersubstrat für den Resonator auch aus einem einfachen und billigeren Keramiksubstrat bestehen. Wichtig ist dabei, daß die thermisch/mechanischen Eigenschaften der beiden Trägersubstratmaterialien möglichst gleich sind, damit während des Betriebs keine durch unterschiedliche Ausdehnung der beiden Substrate bedingten Störungen hervorgerufen werden, die eine Verschlechterung der elektrischen Leistungsmerkmale des Oszillators zur Folge haben könnten.

## Patentansprüche

1. Spannungsgesteuerter Mikrowellenoszillator in Planartechnik, mit einem Mikrowellentransistor (1) als aktivem Bauelement und einem daran angeschlossenen frequenzbestimmenden Schaltungsnetzwerk, welches eine Varaktordiode und einen dielektrischen Resonator (3) enthält, wobei der dielektrische Resonator (3) über eine erste Streifenleitung (L₁) an das Schaltungsnetzwerk angekoppelt ist und der Mikrowellentransistor (1) mit einem ersten (G) seiner drei Tore (G, D, S) über die Varaktordiode (2) an das eine Ende (4) der ersten Streifenleitung (L₁) angeschlossen ist, dadurch gekennzeichnet, daß zwischen Varakrdiode (2) und dem damit verbundenen ersten Tor (G) des Mikrowellentransistors (1) ein sternförmig ausgebildetes Streifenleitungsnetzwerk (L₂-L₄) geschaltet ist mit einem ersten Anschluß an der Varaktordiode (2), einem zweiten Anschluß an dem Tor (G) des Mikrowellentransistors (1) und mindestens einem Anschluß an Bezugspotential, z.B. Masse.

2. Mikrowellenoszillator nach Anspruch 1, dadurch gekennzeichnet, daß das andere Ende (5) der ersten Streifenleitung über einen Abschlußwiderstand, vorzugsweise einen 50 Ω-Widerstand (6) an eine Gleichspannungsquelle (9) angeschlossen ist.

3. Mikrowellenoszillator nach Anspruch 2, dadurch gekennzeichnet, daß der Verbindungspunkt (7) zwischen dem Abschlußwiderstand (6) und der Gleichspannungsquelle (9) über einen Kondensator (8) an Bezugspotential, z.B. Masse angeschlossen ist.

4. , Mikrowellenoszillator nach Anspruch 1, dadurch gekennzeichnet, daß das sternförmig ausgebildete Streifenleitungs-netzwerk (L₂-L₄) aus einer zweiten, dritten und vierten Streifenleitung (L₂, L₃ ,L₄) besteht und daß diese drei Streifenleitungen (L₂, L₃ ,L₄) sternförmig an einen Punkt (10) miteinander verbunden sind.

5. Mikrowellenoszillator nach Anspruch 4, dadurch gekennzeichnet, daß die an Bezugspotential, z.B. Masse angeschlossene vierte Streifenleitung (L₄) in ihrer Länge gleich oder zumindest annähernd gleich ist einem Viertel der Wellenlänge bei der Schwingfrequenz des Oszillators.

6. Mikrowellenoszillator nach einem der vorhergehenden Ansprüche, dadurch gekennzeichnet, daß das zweite Tor (S) des Mikrowellentransistors an eine fünfte Streifenleitung (L₅) angeschlossen ist zur Erzeugung eines negativen Widerstands am dritten Tor (D) und daß das dritte Tor (D) über ein Anpaßnetzwerk (11) an den Ausgang (12) des Mikrowellenoszillators angeschlossen ist.

7. Mikrowellenoszillator nach einem der Ansprüche 1 bis 6, dadurch gekennzeichnet, daß die gesamte Ozsillatorschaltung auf einem einzigen ersten Trägersubstrat aufgebracht ist.

8. Mikrowellenoszillator nach einem der Ansprüche 1 bis 6, dadurch gekennzeichnet, daß die Oszillatorschaltung mit Ausnahme des dielektrischen Resonators (3) auf einem ersten Trägersubstrat und der dielektrisch Resonator (3) auf einem separaten zweiten Trägersubstrat aufgebracht sind.

## Claims

1. Voltage-controlled microwave oscillator in planar technique, comprising a microwave transistor (1) as active component and a frequency-determining circuit network which is connected thereto and which comprises a varactor diode and a dielectric resonator (3), wherein the dielectric resonator (3) is coupled to the circuit network by way of a first strip conductor (L₁) and the microwave transistor (1) is connected at a first one (G) of its three gates (G, D, S) to one end (4) of the first strip conductor (L₁) by way of the varactor diode (2), characterised thereby that a strip conductor network (L₂ to L₄) constructed in star shape with a first connection to the varactor diode (2), a second connection to the gate (G) of the microwave transistor (1) and at least one connection to a reference potential, for example ground, is connected between varactor diode (2) and the first gate (G), which is connected therewith, of the microwave transistor (1).

2. Microwave oscillator according to claim 1, characterised thereby that the other end (5) of the first strip conductor is connected by way of a terminating resistance, preferably a 50 ohm resistance (6), to a direct voltage source (9).

3. Microwave oscillator according to claim 2, characterised thereby that the connecting point (7) between the terminating resistance (6) and the direct voltage source (9) is connected to reference potential, for example ground, by way of a capacitor (8).

4. Microwave oscillator according to claim 1, characterised thereby that the strip conductor (L₂ to L₄) constructed in star shape consists of a second, third and fourth strip conductor (L₂, L₃, L₄) and that these three strip conductors (L₂, L₃, L₄) are connected together in star shape at a point (10).

5. Microwave oscillator according to claim 4, characterised thereby that the fourth strip conductor (L₄), which is connected to reference potential, for example ground, is equal or at least approximately equal in its length to a quarter of the wavelength at the oscillation frequency of the oscillator.

6. Microwave oscillator according to one of the preceding claims, characterised thereby that the second gate (S) of the microwave transistor is connected to a fifth strip conductor (L₅) for generation of a negative resistance at the third gate (D) and that the third gate (D) is connected to the output (12) of the microwave oscillator by way of a matching network (11).

7. Microwave oscillator according to one of claims 1 to 6, characterised thereby that the entire oscillator circuit is mounted on a single first carrier substrate.

8. Microwave oscillator according to one of claims 1 to 6, characterised thereby that the oscillator circuit with the exception of the dielectric resonator (3) is mounted on a first carrier substrate and the dielectric resonator (3) is mounted on a separate second carrier substrate.

## Revendications

1. Oscillateur micro-ondes commandé par la tension, en technique planar, comportant un transistor hyperfréquence (1) comme composant actif et un circuit, déterminant la fréquence, qui lui est relié et contient une diode à capacité variable et un résonateur diélectrique (3), dans lequel le résonateur diélectrique (3) est couplé au circuit par l'intermédiaire d'une première ligne triplaque (L₁) et dans lequel le transistor hyperfréquencc (1) est relié, par une première (G) de ses trois portes (G, D, S) et par l'intermédiaire de la diode à capacité variable (2), à la première extrémité de la première ligne triplaque (L₁), caractérisé par le fait qu'entre la diode à capacité variable (2) et la première porte (G), qui lui est reliée, du transistor hyperfréquence (1) est monté un circuit de lignes triplaques (L₂-L₄) en forme d'étoile avec une première borne à la diode à capacité variable (2), une seconde borne à la porte (G) du transistor hyperfréquence (1) et au moins une borne au potentiel de référencc, par exemple à la masse.

2. Oscillateur micro-ondes selon la revendication 1, caractérisé par le fait que l'autrc extrémité (5) de la première ligne triplaque est reliée à une source de tension continue (9) par l'intermédiaire d'unc résistance de terminaison, de préférence une résistance de 50 Ω (6).

3. Oscillateur micro-ondes selon la revendication 2, caractérisé par le fait que le point de liaison (7) entre la résistance de terminaison (6) et la source de tension continue (9) est relié à un potentiel de référence, par exemple à la masse, par l'intermédiairc d'un condcnsateur (8).

4. Oscillateur micro-ondes selon la revendication 1, caractérisé par le fait que le réseau de lignes triplaques (L₂-L₄) en forme d'étoile est constitué d'une seconde, d'une troisième et d'une quatrième lignes triplaques (L₂, L₃, L₄) et que ces trois lignes triplaques (L₂, L₃, L₄) sont réunies l'une à l'autre en forme d'étoile en un point (10).

5. Oscillateur micro-ondes selon la revendication 4, caractérisé par le fait que la quatrième ligne triplaque (L₄), reliée à un potentiel de référencc, par exemple à la masse, est, en longueur, égale ou au moins approximativement égale au quart de la longueur d'onde pour la fréquence d'oscillation de l'oscillateur.

6. Oscillateur micro-ondes selon l'une des revendications précédcntcs, caractérisé par le fait que la seconde porte (S) du transistor hyperfréquence est reliée à une cinquième ligne triplaque (L₅) pour produire une résistance négative à la troisième porte et que la troisième porte (D) est reliée à la sortie (12) de l'oscillateur micro-ondes par l'intermédiaire d'un circuit d'accord (11).

7. Oscillateur micro-ondes selon l'une des revendications 1 à 6, caractérisé par le fait que l'ensemble du circuit oscillateur est appliqué sur un unique premier substrat support.

8. Oscillateur micro-ondes selon l'une des revendications 1 à 6, caractérisé par le fait qu'à l'execption du résonateur diélectrique (3), le circuit oscillateur est appliqué sur un premier substrat support et que le résonateur diélectrique (3) l'est sur un second substrat support distinct.
